(19) Europäisches Patentamt / European Patent Office / Office européen des brevets

(11) **EP 2 249 481 A1**

(12) **EUROPEAN PATENT APPLICATION**
published in accordance with Art. 153(4) EPC

(43) Date of publication:
**10.11.2010 Bulletin 2010/45**

(51) Int Cl.:
***H03M 13/29*** (2006.01)

(21) Application number: **09709527.7**

(22) Date of filing: **13.02.2009**

(86) International application number:
**PCT/JP2009/052400**

(87) International publication number:
**WO 2009/102012 (20.08.2009 Gazette 2009/34)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **14.02.2008 JP 2008033252**

(71) Applicant: **Sharp Kabushiki Kaisha**
**Osaka-shi, Osaka 545-8522 (JP)**

(72) Inventors:
• **YOKOMAKURA, Kazunari**
**Osaka 545-8522 (JP)**

• **HAMAGUCHI, Yasuhiro**
**Osaka 545-8522 (JP)**
• **NAMBA, Hideo**
**Osaka 545-8522 (JP)**
• **TO, shimpei**
**Osaka 545-8522 (JP)**

(74) Representative: **Müller - Hoffmann & Partner Patentanwälte**
**Innere Wiener Strasse 17**
**81667 München (DE)**

(54) **DECODING DEVICE, DECODING METHOD, DECODING PROGRAM, RECEPTION DEVICE, AND COMMUNICATION SYSTEM**

(57) A decoding device which decodes error correction coded information by iterating a decoding process. The decoding device includes an iteration quantity determination unit which calculates a mutual information indicating a relationship with transmission information of the coded information and determines the number of iterations of the decoding process based on the calculated mutual information.

FIG. 3

**Description**

TECHNICAL FIELD

The present invention relates to a decoding device, a decoding method, a decoding program, a reception device, and a communication system.
This application is based on Japanese Patent Application No. 2008-033252 filed on February 14, 2008, the contents of which are hereby incorporated by reference.

BACKGROUND ART

Recently, it has been assumed that an error correction code which corrects in advance a bit error in a transmission device is used against the effect of distortion by a propagation channel or disturbance by noise in a reception device when information is transmitted from the transmission device to the reception device in a wireless communication system. Particularly, an error correction code having a strong error correction capability is a turbo code discovered in 1993, which is being currently introduced into various wireless communication systems, as a code close to a theoretical limit achievable in a communication system. A transmission side having the same two encoding units in parallel for a turbo code may generate code bits having two independent constraint conditions by rearranging input information thereof via an interleaver. Thus, a reception side includes two decoding units and gradually improves the reliability of transmission information by an iterative process of exchanging the reliability of mutually obtained information, so that the property close to the Shannon limit is achieved.
This turbo decoding process is implemented by iterating a decoding process any number of times. In Patent Document 1, a method of controlling iteration by whether decoded information is positive or negative for low power consumption of a reception device has been proposed.
Patent Document 1: Japanese Unexamined Patent Publication, First Publication No. 2000-183758

DISCLOSURE OF INVENTION

Problem to be Solved by the Invention

However, there is the case where an error is not removed even when an information decoding process is iterated several times in a decoding process (hereinafter, referred to as a stuck state). In a method of controlling the iteration of the decoding process by whether decoded information is positive or negative, the iteration is performed until an error is removed by detecting the error of the decoded information during the iteration.
Accordingly, a reception device performing the above-described decoding method has a disadvantage in that an unnecessary decoding process is iterated, despite the fact that it is not possible to decode information since an error exists even when the decoding process is iterated several times when the stuck state is reached.
The present invention has been made in view of the above-described points, and provides a decoding device, a decoding method, a decoding program, a reception device, and a communication system that prevent an unnecessary decoding process from being iterated.

Means for Solving the Problem

(1) The present invention has been made to solve the above-described problems. According to an aspect of the present invention, there is provided a decoding device which decodes error correction coded information by iterating a decoding process, the decoding device including: an iteration quantity determination unit which calculates a mutual information indicating a relationship with transmission information of the coded information and determines the number of iterations of the decoding process based on the calculated mutual information.
According to the above-described configuration, the decoding device determines the number of iterations of the decoding process based on the mutual information, thereby preventing an unnecessary decoding process from being iterated.
(2) The aspect of the present invention further including: a storage unit which stores a relationship of the mutual information and the number of iterations, wherein the iteration quantity determination unit specifies the number of iterations corresponding to the calculated mutual information from the relationship of the mutual information and the number of iterations stored by the storage unit, and sets the specified number of iterations to the number of iterations of the decoding process.
(3) In the aspect of the present invention, the iteration quantity determination unit determines not to execute the decoding process when the calculated mutual information is less than a preset threshold value.
According to the above-described configuration, the decoding device prevents an unnecessary decoding process from being iterated since the decoding device determines that an error occurs in the case of determining that there is a stuck state in which the mutual information is a value less than the preset threshold value.

(4) In the aspect of the present invention, the threshold value is a mutual information which does not become 1 even when the decoding process of the preset number of iterations is executed.

(5) In the aspect of the present invention, the error correction coding is turbo coding.

(6) According to another aspect of the present invention, there is provided a decoding method which decodes error correction coded information by iterating a decoding process, the decoding method including: calculating a mutual information indicating a relationship with transmission information of the coded information; and determining the number of iterations of the decoding process based on the calculated mutual information.

(7) According to further another aspect of the present invention, there is provided a decoding program which causes a computer of a decoding device, which decodes error correction coded information by iterating a decoding process, the decoding program including: calculating a mutual information indicating a relationship with transmission information of the coded information and determining the number of iterations of the decoding process based on the calculated mutual information.

(8) According to further another aspect of the present invention, there is provided a reception device having a decoding device which decodes error correction coded information included in a reception signal by iterating a decoding process, the reception device including: an iteration quantity determination unit which calculates a mutual information indicating a relationship with transmission information of the coded information and determines the number of iterations of the decoding process based on the calculated mutual information.

(9) According to further another aspect of the present invention, there is provided a communication system including a transmission device and a reception device having a decoding device which decodes error correction coded information included in a signal transmitted from the transmission device by iterating a decoding process, the communication system including: an iteration quantity determination unit which calculates a mutual information indicating a relationship with transmission information of the coded information and determines the number of iterations of the decoding process based on the calculated mutual information.

Effect of the Invention

According to the present invention, a decoding device prevents an unnecessary decoding process from being iterated since the number of iterations of a decoding process is determined based on a mutual information.

BRIEF DESCRIPTION OF THE DRAWINGS

FIG. 1 is a schematic block diagram showing the configuration of a transmission device.
FIG. 2 is a schematic block diagram showing the configuration of an RSC encoding unit.
FIG. 3 is a schematic block diagram showing the configuration of a reception device according to an embodiment of the present invention.
FIG. 4 is an illustrative diagram showing a relationship of the number of iterations and input/output characteristics of a mutual information according to an embodiment of the present invention.
FIG. 5 is a flowchart showing the operation of the transmission device according to an embodiment of the present invention.
FIG. 6 is a flowchart showing the operation of the reception device according to an embodiment of the present invention.

Reference Symbols

| | |
|---|---|
| 1: | ENCODING DEVICE |
| 11: | INTERLEAVER |
| 12: | RSC ENCODING UNIT |
| 13: | RSC ENCODING UNIT |
| 14: | PUNCTURING UNIT |
| 2: | WIRELESS TRANSMISSION UNIT |
| 3: | TRANSMISSION ANTENNA |
| 121-1 to 121-3: | ADDER |

122-1 to 122-3:    SHIFT REGISTER
4:                        RECEPTION ANTENNA
5:                        WIRELESS RECEPTION UNIT
6:                        DECODING DEVICE
60:                      LLR CALCULATION UNIT
61:                      ITERATION QUANTITY DETERMINATION UNIT
62:                      STORAGE UNIT
63:                      FIRST INTERLEAVER
64:                      DE-PUNCTURING UNIT
65:                      MAP ESTIMATION UNIT
66:                      DE-INTERLEAVER
67:                      INTERLEAVER
68:                      MAP ESTIMATION UNIT
69:                      ITERATION CONTROL UNIT
601-1 to 601-2:    ADDER


BEST MODE FOR CARRYING OUT THE INVENTION


(Embodiments)


Embodiments of the present invention will now be described in detail with reference to the drawings. In this embodiment, a communication system includes a transmission device and a reception device. Here, the reception device of the communication system receives a transmission signal including information error-correction coded by the transmission device. Then, the reception device decodes by iterating a decoding process for the information. In this embodiment, the error correction code is a turbo code, and a coding rate of the turbo code is set to 1/2.

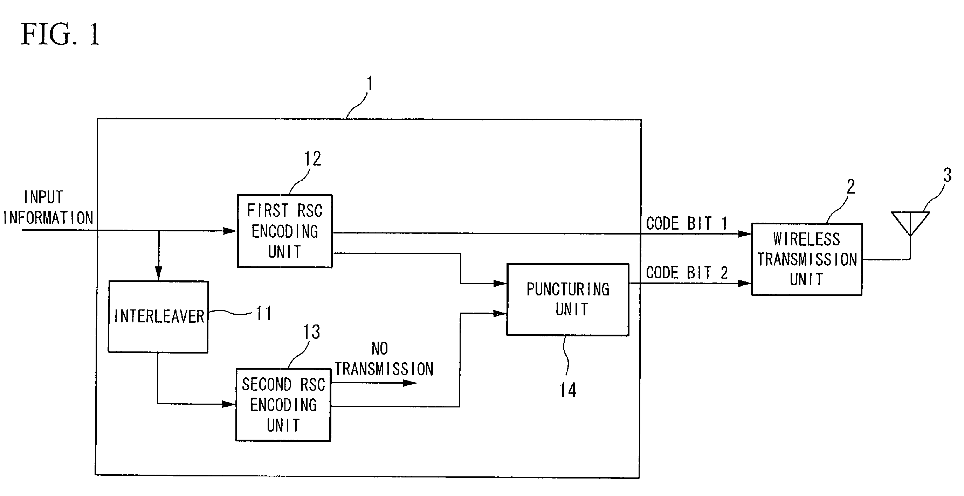

FIG. 1 is a schematic block diagram showing the configuration of the transmission device. The transmission device includes an encoding unit 1, a wireless transmission unit 2, and a transmission antenna 3.
The encoding unit 1 includes an interleaver 11, a first RSC (Recursive Systematic Convolutional) encoding unit 12, a second RSC encoding unit 13, and a puncturing unit 14.

Input information input to the encoding device 1 is input to the interleaver 11 and the first RSC encoding unit 12 in a bit unit. Hereinafter, information of the bit unit is referred to as an information bit.
The first RSC encoding unit 12 generates a systematic bit and a parity bit 1 from the input information bit. The first RSC encoding unit 12 outputs the generated systematic bit as a code bit 1 to the wireless transmission unit 2. The first RSC encoding unit 12 outputs the generated parity bit 1 to the puncturing unit 14. Details of the configuration of the first RSC encoding unit 12 will be described later.

The interleaver 11 creates an information bit to which the input information bit has been rearranged, and outputs the created information bit to the second RSC encoding unit 13.
The second RSC encoding unit 13 generates a systematic bit and a parity bit 2 from the information bit input from the interleaver 11. The second RSC encoding unit 13 outputs the generated parity bit 2 to the puncturing unit 14. Also, the second RSC encoding unit 13 does not output the generated systematic bit and does not transmit the generated systematic bit to the reception device.

The puncturing unit 14 punctures the parity bit 1 input from the first RSC encoding unit 12 and the parity bit 2 input from the second RSC encoding unit 13 in response to a coding rate. In this embodiment, since the coding rate is set to 1/2, the puncturing unit 14 generates a code bit 2 corresponding to the code bit 1. Specifically, the puncturing unit 14 generates the code bit 2 and outputs the generated code bit 2 to the wireless transmission unit 2 by alternately puncturing the parity bit 1 input from the first RSC encoding unit 12 and the parity bit 2 input from the second RSC encoding unit 13.

The wireless transmission unit 2 transmits an information bit (hereinafter, referred to as a transmission bit) input from the encoding device 1 to the reception device. Specifically, the wireless transmission unit 2 respectively converts the code bit 1 and the code bit 2 input from the puncturing unit 14 into analog signals by digital/analog conversion, up-converts the analog signals into radio frequency signals as a transmission signal 1 and a transmission signal 2, and transmits the transmission signal 1 and the transmission signal 2 to the reception device via a transmission antenna 3.

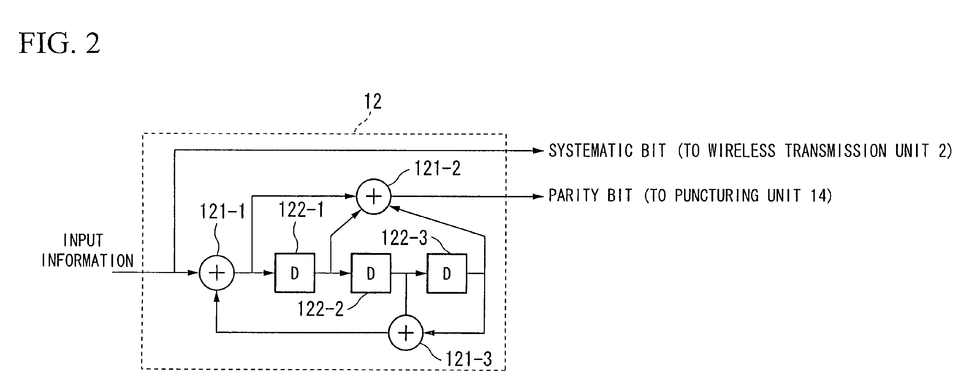

FIG. 2 is a schematic block diagram showing the configuration of the first RSC encoding unit 12.
The first RSC encoding unit 12 shown in FIG. 2 generates an RSC code of a constraint length 4. The RSC encoding unit 12 includes adders 121-1 to 121-3 and shift registers 122-1 to 122-3 which perform an exclusive OR calculation.
The first RSC encoding unit 12 generates a systematic bit and a parity bit 1 from an input information bit according to a circuit operation for one clock, and respectively outputs the systematic bit and the parity bit 1 to the wireless transmission unit 2 and the puncturing unit 14. Here, the systematic bit corresponds to the information bit, and the parity bit is a bit generated by performing a convolution by the exclusive OR operation on a plurality of information bits for error correction of the information bit.

Also, the second RSC encoding unit 13 has the same function as the RSC encoding unit 12. The second RSC encoding unit 13 generates a systematic bit and a parity bit 2 from the information bit input from the interleaver 11, and outputs only the generated parity bit 2 to the puncturing unit 14. FIG. 1 and 2 respectively show a transmission device using the known turbo coding and the first RSC encoding unit thereof.

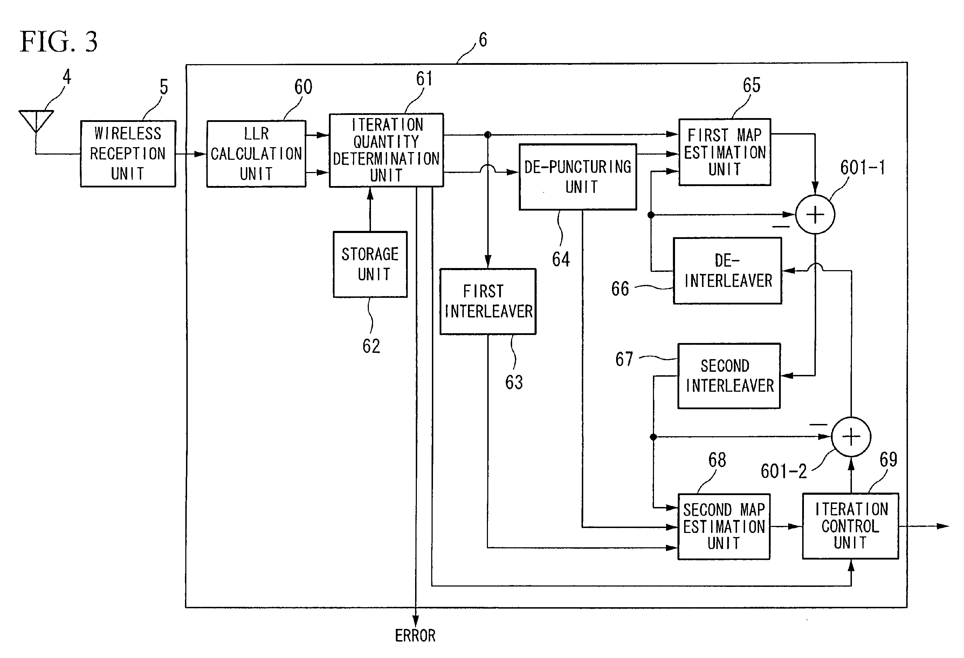

FIG. 3 is a schematic block diagram showing the configuration of the reception device according to this embodiment. The reception device includes a reception antenna 4, a wireless reception unit 5, and a decoding device 6. The decoding device 6 includes an LLR (Log Likelihood Ratio) calculation unit 60, an iteration quantity determination unit 61, a storage unit 62, a first interleaver 63, a de-puncturing unit 64, a first MAP estimation unit 65, a de-interleaver 66, a second interleaver 67, a second MAP estimation unit 68, an iteration control unit 69, a first adder 601-1, and a second adder 601-2.

The reception antenna 4 receives a signal transmitted from the transmission device, and outputs the received signal to the wireless reception unit 5. The wireless reception unit 5 down-converts the received signal input from the reception antenna 4 from a radio frequency signal into a baseband signal, and next outputs reception information converted into a digital signal by analog/digital conversion to the decoding device 6 in a bit unit. Hereinafter, the reception information of the bit unit is referred to as a reception information bit. It is assumed that a reception information bit corresponding to the transmission signal 1 transmitted by the transmission device is a reception information bit 1 and a reception information bit corresponding to the transmission signal 2 is a reception information bit 2.

The LLR calculation unit 60 of the decoding device 6 measures a variance of the reception information bit 1 and a variance of the reception information bit 2 from the reception information bits input from the wireless reception unit 5, and respectively calculates log likelihood ratios.

Hereinafter, a specific calculation method to be performed by the LLR calculation unit will be described. The log likelihood ratio is defined in Equation (1).

[Equation 1]

$$l(k) = \ln\left[\frac{p(y \mid x(k)=1)}{p(y \mid x(k)=0)}\right] \cdots (1)$$

In Equation (1), 1(k) denotes the log likelihood ratio of a $k^{th}$ bit, x(k) denotes a $k^{th}$ transmission bit (0 or 1), and y denotes a vector in which measured reception information bits are arranged. In Equation (1), p(y|x(k)=1) and p(y|x(k)=O) respectively denote probability density functions of bit values of the vector y when bit values of the transmission bit x(k) are 1 and 0.

Assuming that the probability density function is a Gaussian distribution, the log likelihood ratio becomes Equation (2).
[Equation 2]

$$l(k) = \frac{2}{\sigma^2} y(k) \cdots (2)$$

In Equation (2),1(k) denotes the log likelihood ratio of the $k^{th}$ bit, y(k) denotes a $k^{th}$ reception information bit, and $\sigma^2$ is the variance of a reception information bit (the variance of noise). Equation (2) is the case where a modulation scheme is BPSK (Binary Phase Shift Keying), but the present invention is not limited thereto. Other modulation schemes are possible. Calculation expressions of the other modulation schemes will be described later.

In this embodiment, the LLR calculation unit 60 measures the variance $\sigma^2$ of a reception information bit and measures a log likelihood ratio using Equation (2). The LLR calculation unit 60 outputs the calculated log likelihood ratio to the iteration quantity determination unit 61. Here, the LLR calculation unit 60 outputs a log likelihood ratio (hereinafter, referred to as an LLR 1) calculated from the reception information bit 1 and a log likelihood ratio (hereinafter, referred to as an LLR 2) calculated from the reception information bit 2 to the iteration quantity determination unit 61.

The iteration quantity determination unit 61 calculates a mutual information indicating a relationship with the transmission information based on the log likelihood ratios input from the LLR calculation unit 60, and determines the number of iterations of a decoding process based on the mutual information.

Hereinafter, a method of determining the number of iterations to be performed by the iteration quantity determination unit 61 will be described. First, a relationship of the number of iterations and a mutual information will be described, a method of calculating a mutual information from a log likelihood ratio calculated by the LLR calculation unit 60 will next be described, and a method of determining the number of iterations from the calculated mutual information will be described.

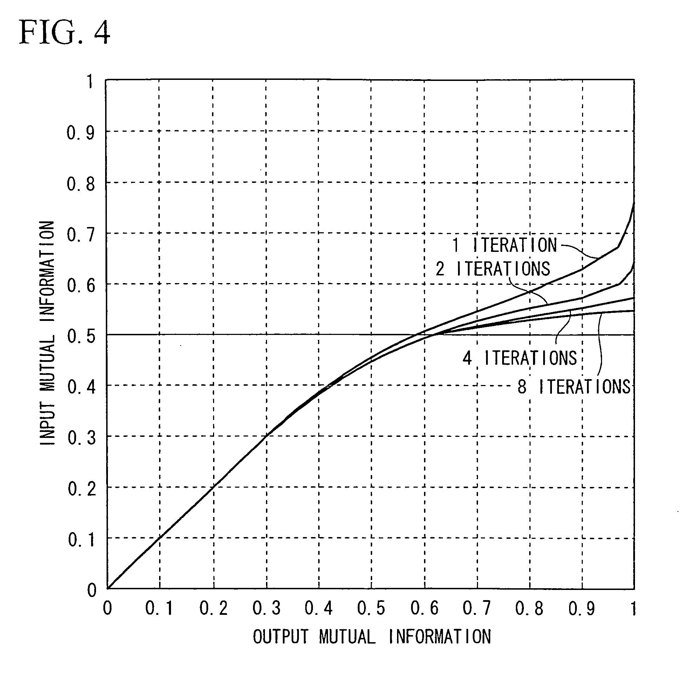

FIG. 4 is an illustrative diagram showing a relationship of the number of iterations and input/output characteristics of a mutual information. In FIG. 4, the vertical axis is a mutual information (hereinafter, referred to as an input mutual information) input to a decoding process, and the horizontal axis is a mutual information (hereinafter, referred to as an output mutual information) output from the decoding process, which is restricted to a value of 0 to 1. FIG. 4 respectively shows a relationship of an input mutual information and an output mutual information when the number of iterations of the decoding process is 1 (1 iteration), 2 (2 iterations), 4 (4 iterations), and 8 (8 iterations).

The mutual information is a numerical value of an information amount obtained in relation to transmission information when reception information is obtained in an information theory. When the mutual information is 0, it means that no information regarding the transmission information is obtained from the reception information. When the mutual information is 1, it means that information regarding the transmission information is completely obtained from the reception information.

FIG. 4 shows that an input mutual information corresponding to an output mutual information of 1 becomes small as the number of iterations of a decoding process becomes large, and that the error correction capability becomes high as the number of iterations becomes large. For example, the output mutual information becomes 1 by iterating the decoding process twice when the input mutual information is equal to or greater than 0.65, but the output mutual information becomes 1 by iterating the decoding process 8 times when the input mutual information is equal to or greater than 0.55.

Here, characteristics are uniquely determined as long as the constraint length is the same and the coding rate is the same since an input/output relationship of a mutual information in decoding is implemented by the convolution according to a specific rule of an information bit in an encoding device. That is, the decoding device 6 is able to recognize the input/output relationship of a mutual information before decoding and to determine the number of iterations and the presence/absence of a decoding process as long as the constraint length and the coding rate available in the encoding device 1 of the transmission device are known.

In this embodiment, the storage unit 62 of the encoding device 6 stores a relationship of the number of iterations and the mutual information as shown in Table 1.

[Table 1]

| Input Mutual Information | Number of Iterations |
| --- | --- |
| ~ 0.55 | 0 (Error without decoding) |
| 0.555 ~ 0.575 | 8 |
| 0.575 ~ 0.65 | 4 |
| 0.65 ~ 0.75 | 2 |
| 0.75 ~ | 1 |

In Table 1, values of the input mutual information are values when the output mutual information becomes 1 for each number of iterations of the decoding process in FIG. 4. For example, in FIG. 4, the output mutual information becomes 1 when the input mutual information is equal to or greater than 0.575 in the case where the number of iterations of the decoding process is 4, and the output mutual information becomes 1 when the input mutual information is equal to or greater than 0.65 in the case where the number of iterations of the decoding process is 2. Accordingly, Table 1 shows that it is possible to obtain the output mutual information having a value of 1 by iterating the decoding process at least 4 times when a value of the input mutual information is 0.575 to 0.65.

Here, an upper limit of the number of iterations of the decoding process determined by the iteration quantity determination unit 61 is determined in advance, and an upper limit of the input mutual information in which the output mutual information does not become 1 even in the decoding process of the determined number of iterations is preset as a threshold value. In this embodiment, the number of iterations of the decoding process is maximally set to 8. In FIG. 4, when the number of iterations is 8, the output mutual information does not become 1 in the case of 0.55 or less, and a threshold value as an upper limit thereof is 0.55.

When the input mutual information is less than 0.55 as the threshold value, the iteration quantity determination unit 61 sets the number of iterations to 0 as an error, that is, determines not to execute the decoding process for reception information.

Next, a method of calculating a mutual information from log likelihood ratios calculated by the LLR calculation unit 60 will be described. The iteration quantity determination unit 61 calculates the mutual information using Equation (3) from the log likelihood ratios calculated by the LLR calculation unit 60.

[Equation 3]

$$I = 1 - \frac{2}{K_B} \sum_{k=1}^{K_B} \frac{\log_2\left(1 + \exp(-l_k)\right)}{1 + \exp(-l_k)} \quad \cdots \quad (3)$$

In Equation (3), I is a value of the mutual information indicating a real number between 0 and 1, and $K_B$ is the number (natural number) of transmission bits to be transmitted in one transmission opportunity. $l_k$ is the log likelihood ratio of the $k^{th}$ transmission bit, is calculated by the LLR calculation unit 60, and is input to the iteration quantity determination unit 61.

Hereinafter, the deduction of Equation (3) will be described. In general, when reception information has been obtained, the mutual information I regarding transmission information is defined by Equation (4) using the log likelihood ratio.

[Equation 4]

$$I = \int_{-\infty}^{\infty} \int_{-\infty}^{\infty} p(l,x) \log_2 \frac{p(l,x)}{p(l)p(x)} dl dx \quad \cdots \quad (4)$$

In Equation (4), I is the log likelihood ratio of a real number and x is the transmission information of a real number. Here, the transmission information becomes -1 when the transmission bit is 0, and becomes 1 when the transmission bit is 1. That is, x has only -1 or 1, and a sum of probabilities becomes 1 when x=-1 and x=1. In this embodiment, Equation (4) becomes Equation (5) since the log likelihood ratio follows a Gaussian distribution.

[Equation 5]

$$I = \frac{1}{2} \sum_{x=-1,+1} \int_{-\infty}^{\infty} p(l\,|\,x) \log_2 \frac{2p(l\,|\,x)}{p(l\,|\,x=-1) + p(l\,|\,x=1)} dl dx \quad \cdots \quad (5)$$

$$= 1 - \int_{-\infty}^{\infty} p(l\,|\,x=+1) \log_2\left[1 + \exp(-l)\right] dl$$

Since p(1|x=+1) is rewritten as 2×p(1) p(x=+1|1) from Bayes' theorem, Equation (5) becomes Equation (6).
[Equation 6]

$$I = 1 - 2 \int_{-\infty}^{\infty} p(l)p(x = +1 \mid l) \log_2 \left[ 1 + \exp(-l) \right] dl$$

$$= 1 - 2E \left[ p(x = +1 \mid l) \log_2 \left[ 1 + \exp(-l) \right] \right]$$

$\cdots$ (6)

In Equation (6), E[x] is an operator for calculating an expectation value of x. Here, in general, it is known that a mean value and a variance of the log likelihood ratio become 1:2. p(x=+1|1) becomes $(1+\exp(-1))^{-1}$ when the case following the Gaussian distribution is also considered.
From the above, Equation (6) becomes Equation (3).
Next, a method of determining the number of iterations from the mutual information calculated by Equation (3) will be described. The iteration quantity determination unit 61 specifies the number of iterations corresponding to the calculated mutual information I from the relationship (Table 1) of the mutual information and the number of iterations stored in the storage unit 62, and determines the specified number of iterations as that of the decoding process.
For example, the iteration quantity determination unit 61 determines the number of iterations as 2 since a value of the input mutual information of Table 1 is 0.65 to 0.75 when a value of the calculated mutual information is 0.7, and determines the number of iterations as 4 since a value of the input mutual information of Table 1 is 0.575 to 0.65 when a value of the calculated mutual information is 0.6.
When the calculated mutual information is less than the preset threshold value, the iteration quantity determination unit 61 determines not to execute the decoding process for reception information by setting it as an error.
Specifically, the iteration quantity determination unit 61 determines the number of iterations as 0 since a value of the input mutual information of Table 1 is ~ 0.55 when the calculated mutual information is 0.5, and sets it as an error without executing the decoding process for reception information.
The iteration quantity determination unit 61 outputs the determined number of iterations to the iteration control unit 69. The iteration quantity determination unit 61 outputs the LLR 1 input from the LLR calculation unit 60 to the first interleaver 63 and the first MAP estimation unit 65, and outputs the LLR 2 to the de-puncturing unit 64.
The interleaver 63 performs the same rearrangement as the first interleaver 11 of FIG. 1 for the LLR 1 input from the iteration quantity determination unit 61, and outputs the rearrangement result to the second MAP estimation unit 68.
For the LLR 2 input from the iteration quantity determination unit 61, the de-puncturing unit 64 outputs a log likelihood ratio corresponding to the parity bit 1 to the first MAP estimation unit 65, and outputs a log likelihood ratio corresponding to the parity bit 2 to the second MAP estimation unit 68.
Specifically, the de-puncturing unit 64 alternately outputs a log likelihood ratio corresponding to the code bit 2 to the first MAP estimation unit 65 and the second MAP estimation unit 68. At this time, the de-puncturing unit 64 adds 0 as a dummy bit to the MAP estimation unit 65 or the second MAP estimation unit 68 to which the log likelihood ratio corresponding to the code bit 2 is not output.
The first MAP estimation unit 65 estimates MAP (Maximum A posteriori Probability) based on the LLR 1 input from the iteration quantity determination unit 61, the log likelihood ratio corresponding to the parity bit 1 input from the de-puncturing unit 64, and a priori information input from the de-interleaver 66, and performs error correction. Here, the a priori information input from the de-interleaver 66 is the reliability of an information bit obtained from the second MAP estimation unit 68, and becomes 0 since the reliability is not obtained in the first process.
The first MAP estimation unit 65 outputs a log likelihood ratio for which the above-described error correction has been performed to the first adder 601-1.
The first adder 601-1 subtracts the a priori information input from the de-interleaver 66 from the log likelihood ratio input from the first MAP estimation unit 65, and outputs the variation of the log likelihood ratio by the first MAP estimation unit 65 to the second interleaver 67.
The second interleaver 67 performs the same rearrangement as the interleaver 11 of FIG. 1 for the log likelihood ratio input from the first adder 601-1, and outputs the rearrangement result to the second MAP estimation unit 68.
The second MAP estimation unit 68 estimates maximum a posteriori probability (MAP) based on the rearranged LLR 1 input from the first interleaver 63, the log likelihood ratio corresponding to the parity bit 2 input from the de-puncturing unit 64, and the a priori information input from the second interleaver 67, and performs error correction.
The second MAP estimation unit 68 outputs the log likelihood ratio for which the above-described error correction has been performed to the iteration control unit 69.

When the above-described log likelihood ratio is input from the MAP estimation unit 67, the iteration control unit 69 counts the number of error correction processes and increments the number thereof by 1. The error correction process is iterated until the number of error correction processes reaches the number of iterations input from the iteration quantity determination unit 61.

The iteration control unit 69 completes decoding by outputting decoded information when the number of error correction processes has reached the number of iterations input from the iteration quantity determination unit 61.

When the counted number of error correction processes has not reached the number of iterations input from the iteration quantity determination unit 61, the iteration control unit 69 outputs the log likelihood ratio input from the second MAP estimation unit 68 to the second adder 601-2.

The second adder 601-2 subtracts the a priori information input from the second interleaver 67 from the log likelihood ratio input from the iteration control unit 69, and outputs the variation of the log likelihood ratio by the second MAP estimation unit 68 to the de-interleaver 66.

The de-interleaver 66 performs the rearrangement as opposed to the interleaver 11 for the log likelihood ratio corresponding to the code bit 2 input from the second adder 601-2, that is, the rearrangement which returns the information rearranged by the interleaver 11 to the original rearrangement, and outputs the rearrangement result to the first MAP estimation unit 65.

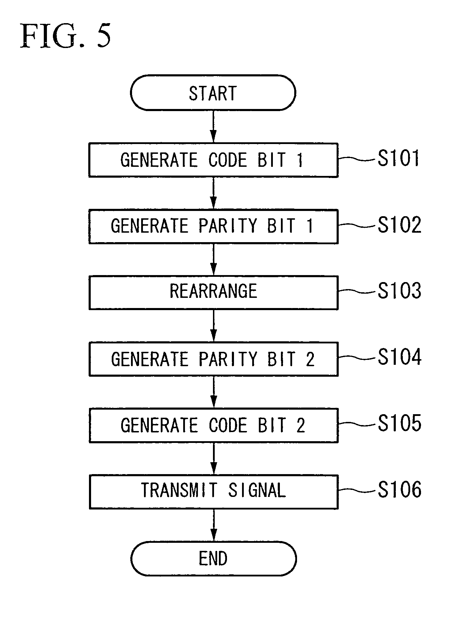

Next, the operation of the reception device in this embodiment will be described. FIG. 5 is a flowchart showing the operation of the reception device in this embodiment.

An information bit input to the encoding device 1 is input to the interleaver 11 and the first RSC encoding unit 12. The first RSC encoding unit 12 generates a systematic bit and a parity bit 1 from the input information bit. The first RSC encoding unit 12 outputs the generated systematic bit as a code bit 1 to the wireless transmission unit 2 (S101). The first RSC encoding unit 12 outputs the generated parity bit 1 to the puncturing unit 14 (S102).

On the other hand, the interleaver 11 creates an information bit to which the input information bit has been rearranged, and outputs the created information bit to the second RSC encoding unit 13 (S103).

The second RSC encoding unit 13 generates a systematic bit and a parity bit 2 from the information bit input from the interleaver 11. The second RSC encoding unit 13 outputs the generated parity bit 2 to the puncturing unit 14 (S104).

The puncturing unit 14 generates a code bit 2 from the parity bit 1 input from the first RSC encoding unit 12 and the parity bit 2 input from the second RSC encoding unit 13, and outputs the code bit 2 to the wireless transmission unit 2 (S105).

The wireless transmission unit 2 up-converts the code bit 1 input from the first RSC encoding unit 12 and the code bit 2 input from the puncturing unit 14 into a radio frequency, and transmits the code bit 1 and the code bit 2 to the reception device via the transmission antenna 3 (S106).

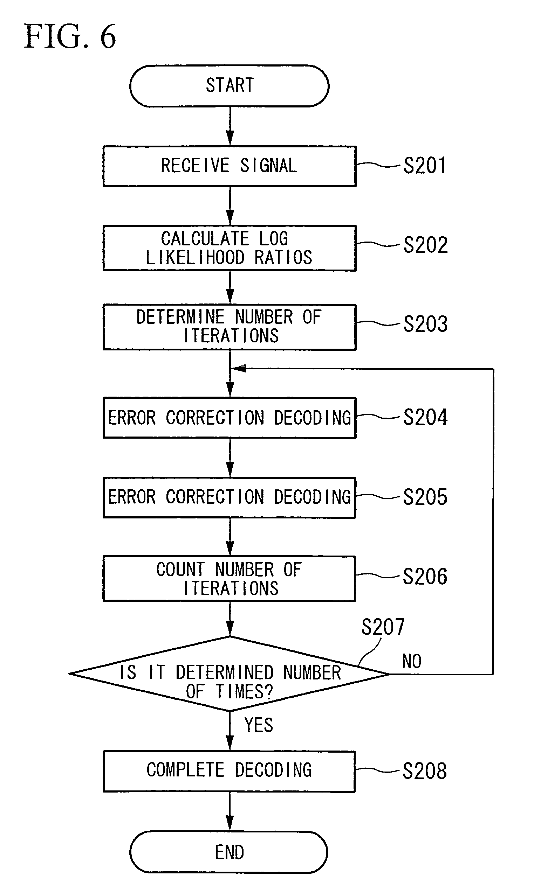

Next, the operation of the transmission device in this embodiment will be described. FIG. 6 is a flowchart showing the operation of the transmission device in this embodiment.

The wireless reception unit 5 down-converts a reception signal input from the reception antenna 4 from the radio frequency, and outputs reception information bits to the decoding device 6 (S201).

The LLR calculation unit 60 calculates log likelihood ratios by measuring variances of information based on the reception information bits input from the wireless reception unit 5 (S202).

The iteration quantity determination unit 61 calculates a mutual information from the log likelihood ratios input from the LLR calculation unit 60, and determines the number of iterations of a decoding process based on the mutual information (S203).

The first MAP estimation unit 65 estimates a maximum a posteriori probability (MAP) based on a log likelihood ratio corresponding to the code bit 1 input from the iteration quantity determination unit 61, a log likelihood ratio corresponding to the parity bit 1 input from the de-puncturing unit 64, and a priori information input from the de-interleaver 66, and performs error correction (S204).

The second MAP estimation unit 68 estimates a maximum a posteriori probability (MAP) based on a log likelihood ratio corresponding to the code bit 2 input from the first interleaver 63, the log likelihood ratio corresponding to the parity bit 2 input from the de-puncturing unit 64, and a priori information input from the second interleaver 67, and performs error correction (S205).

When the log likelihood ratio is input from the MAP estimation unit 67, the iteration control unit 69 counts the number of error correction processes (S206). The iteration control unit 69 determines whether or not the counted number of error correction processes has reached the number of iterations determined by the iteration quantity determination unit 61 (S207).

The iteration control unit 69 completes decoding by outputting the log likelihood ratio input from the second MAP estimation unit 68 as decoded information when the counted number of error correction processes has reached the number of iterations determined by the iteration quantity determination unit 61 (S208).

On the other hand, when the counted number of error correction processes has not reached the number of iterations determined by the iteration quantity determination unit 61, the iteration control unit 69 outputs the log likelihood ratio input from the second MAP estimation unit 68, and the first MAP estimation unit 65 iterates the error correction process (S204).

According to this embodiment as described above, the decoding device 6 calculates a mutual information to be obtained by executing a decoding process for reception information, and determines the number of iterations of the decoding process so that the calculated mutual information becomes 1, that is, a value in which information regarding transmission information is completely obtained from the reception information. Thereby, the decoding device 6 is able to completely obtain information regarding the transmission information by performing the process only a number of times necessary for the mutual information of 1, and is able to reduce a processing amount and a processing delay without degrading the reliability of the decoding process.

According to this embodiment, the decoding device 6 does not perform the decoding process by setting it as an error when the mutual information obtained by executing the decoding process for the reception information does not become 1, that is, when the mutual information for the reception information is less than a preset threshold. Thereby, the decoding device 6 avoids the stuck state in which the mutual information by the decoding process does not become 1 without iterating an unnecessary decoding process.

The encoding device 6 is able to reduce power consumption since consumption power related to the process is not consumed without iterating an unnecessary decoding process.

Equation (2) is the case where a modulation scheme is BPSK in the above-described embodiment, but the present invention is not limited thereto. For example, the modulation scheme may be QPSK (Quaternary Phase Shift Keying). At this time, Equation (2) becomes Equation (7).

[Equation 7]

$$l(2k') = \frac{\sqrt{2}}{\sigma^2}\mathrm{Re}[y(k')]$$
$$\qquad\qquad\qquad \cdots (7)$$
$$l(2k'+1) = \frac{\sqrt{2}}{\sigma^2}\mathrm{Im}[y(k')]$$

In Equation (7), k' is an index of a reception signal. When the modulation scheme is QPSK, the LLR calculation unit 60 calculates LLRs for 2 bits since it is possible to transmit 2-bit information by one reception signal. That is, LLRs for 2 bits of k=2k' and k=2k"+1 are simultaneously calculated in correspondence with Equation (2). Likewise, it is possible to calculate an LLR for each bit even in another modulation scheme such as 16QAM (Quadrature Amplitude Modulation).

A coding rate is 1/2 for coding in the above-described embodiment, but the present invention is not limited thereto. For example, the transmission device sets the coding rate to 1/3 by transmitting the code bit 1, the parity bit 1, and the parity bit 2 from the wireless transmission unit 2 without having the puncturing unit 14. At this time, the reception device does not include the de-puncturing unit 64.

The encoding device 6 includes the LLR calculation unit 60 in the above-described embodiment, but the present invention is not limited thereto. For example, the wireless reception unit 5 may include the LLR calculation unit 60. Specifically, in the case where the wireless reception unit 5 of the reception device includes an equalization unit which corrects distortion by a propagation channel, it is possible to calculate a log likelihood ratio and input the calculated log likelihood ratio to the iteration quantity determination unit at the time of performing demodulation from a signal equalized by the equalization unit.

For example, the equalization unit calculates a log likelihood ratio from a pilot signal used to estimate a propagation channel, and outputs the calculated log likelihood ratio to the iteration quantity determination unit. The iteration quantity determination unit determines the number of iterations of the decoding process from the log likelihood ratio input from the equalization unit.

In this embodiment, the wireless reception unit 5 may have another function in response to a transmission scheme. For example, a function of removing a GI (Guard Interval) and a time-frequency conversion function are provided in an OFDM (Orthogonal Frequency Division Multiplexing) transmission scheme. Also, an equalization function of compensating for distortion of a propagation channel is provided for communication by a single carrier.

An error correction code is a turbo code in the above-described embodiment, but the present invention is not limited thereto. Other error correction codes may be used for an iterative decoding process.

For example, the error correction code may be an LDPC (Low Density Parity Check) code, an RA (Repeat Accumulate) code, or a PA (Product Accumulate) code.

In the above-described embodiment, the transmission device transmits coded information according to a modulation scheme or a coding rate determined in advance, and the reception device determines the number of iterations of the decoding process in which the mutual information becomes 1 from a relationship of the number of iterations of the decoding process of the reception device and the mutual information. Alternatively, the reception device may determine in advance the number of iterations of the decoding process, and the transmission device determines a modulation scheme or a decoding rate in which the mutual information becomes 1 within the number of iterations determined by the reception device from the relationship of the number of iterations of the decoding process of the reception device and the mutual information, and may transmit coded information by the determined modulation scheme or coding rate. For example, when the number of decoding processes of the reception device is limited by whether or not there is the real time property as in streaming, the transmission device which distributes the streaming transmits a signal decoded by a modulation scheme or a decoding rate in which the mutual information becomes 1 by the limited number of times. Thereby, the reception device which receives information of the streaming distributed by the transmission device is able to execute a decoding process in which the mutual information becomes 1 in the limited number of times.

In the above-described embodiment, a control process of the decoding device 6 may be executed by recording a program for implementing functions of respective parts of the decoding device 6 or a part of the functions on a computer readable recording medium of the decoding device or reception device and enabling a computer system to read and execute the program recorded on the recording medium. The "computer system" used herein includes an OS and hardware, such as peripheral devices. The "computer readable recording medium" is a portable medium such as a flexible disc, magneto-optical disc, ROM and CD-ROM, and a storage device, such as a hard disk, built in the computer system. Furthermore, the "computer readable recording medium" may also include a medium that dynamically holds a program for a short period of time, such as a communication line when a program is transmitted via a network such as the Internet or a communication network such as a telephone network, and a medium that holds a program for a fixed period of time, such as a volatile memory in a computer system serving as a server or client in the above situation. The program may be one for implementing part of the above functions, or the above functions may be implemented in combination with a program already recorded on the computer system.

The embodiments of the present invention have been described in detail with reference to the drawings. However, specific configurations are not limited to the embodiments and may include any design in the scope without departing from the subject matter of the present invention.

Industrial Applicability

The present invention is suitable for use in a decoding device, a decoding method, a decoding program, a reception device, a communication system, and technologies similar thereto, and is able to perform decoding without iterating an unnecessary decoding process.

**Claims**

1. A decoding device which decodes error correction coded information by iterating a decoding process, the decoding device comprising:

    an iteration quantity determination unit which calculates a mutual information indicating a relationship with transmission information of the coded information and determines the number of iterations of the decoding process based on the calculated mutual information.

2. The decoding device according to claim 1, further comprising:

    a storage unit which stores a relationship of the mutual information and the number of iterations, wherein the iteration quantity determination unit specifies the number of iterations corresponding to the calculated mutual information from the relationship of the mutual information and the number of iterations stored by the storage unit, and sets the specified number of iterations to the number of iterations of the decoding process.

3. The decoding device according to claim 1 or 2, wherein the iteration quantity determination unit determines not to execute the decoding process when the calculated mutual information is less than a preset threshold value.

**4.** The decoding device according to claim 3,
wherein the threshold value is a mutual information which does not become 1 even when the decoding process of the preset number of iterations is executed.

**5.** The decoding device according to any one of claims 1 to 4,
wherein the error correction coding is turbo coding.

**6.** A decoding method which decodes error correction coded information by iterating a decoding process, the decoding method comprising:

calculating a mutual information indicating a relationship with transmission information of the coded information; and determining the number of iterations of the decoding process based on the calculated mutual information.

**7.** A decoding program which causes a computer of a decoding device, which decodes error correction coded information by iterating a decoding process, the decoding program comprising:

calculating a mutual information indicating a relationship with transmission information of the coded information and determining the number of iterations of the decoding process based on the calculated mutual information.

**8.** A reception device having a decoding device which decodes error correction coded information comprised in a reception signal by iterating a decoding process, the reception device comprising:

an iteration quantity determination unit which calculates a mutual information indicating a relationship with transmission information of the coded information and determines the number of iterations of the decoding process based on the calculated mutual information.

**9.** A communication system comprising a transmission device and a reception device having a decoding device which decodes error correction coded information comprised in a signal transmitted from the transmission device by iterating a decoding process, the communication system comprising:

an iteration quantity determination unit which calculates a mutual information indicating a relationship with transmission information of the coded information and determines the number of iterations of the decoding process based on the calculated mutual information.

FIG. 1

INPUT
INFORMATION

FIRST RSC
ENCODING
UNIT

12

INTERLEAVER — 11

SECOND RSC
ENCODING
UNIT

13

NO
TRANSMISSION

PUNCTURING
UNIT

14

CODE BIT 1

CODE BIT 2

WIRELESS
TRANSMISSION
UNIT

2

3

1

EP 2 249 481 A1

FIG. 2

INPUT
INFORMATION

SYSTEMATIC BIT (TO WIRELESS TRANSMISSION UNIT 2)

PARITY BIT (TO PUNCTURING UNIT 14)

12

121-1  122-1  121-2  122-3

122-2  121-3

EP 2 249 481 A1

FIG. 3

4

5
WIRELESS
RECEPTION
UNIT

60
LLR
CALCULATION
UNIT

61
ITERATION
QUANTITY
DETERMINATION
UNIT

6

65
FIRST MAP
ESTIMATION
UNIT

601-1

62
STORAGE
UNIT

64
DE-PUNCTURING
UNIT

66
DE-
INTERLEAVER

63
FIRST
INTERLEAVER

67
SECOND
INTERLEAVER

68
SECOND MAP
ESTIMATION
UNIT

601-2

69
ITERATION
CONTROL
UNIT

ERROR

FIG. 4

# FIG. 5

```
        ┌──────────────────┐
        │      START       │
        └──────────────────┘
                 │
                 ▼
   ┌──────────────────────────┐
   │   GENERATE CODE BIT 1     │──── S101
   └──────────────────────────┘
                 │
                 ▼
   ┌──────────────────────────┐
   │  GENERATE PARITY BIT 1    │──── S102
   └──────────────────────────┘
                 │
                 ▼
   ┌──────────────────────────┐
   │        REARRANGE          │──── S103
   └──────────────────────────┘
                 │
                 ▼
   ┌──────────────────────────┐
   │  GENERATE PARITY BIT 2    │──── S104
   └──────────────────────────┘
                 │
                 ▼
   ┌──────────────────────────┐
   │   GENERATE CODE BIT 2     │──── S105
   └──────────────────────────┘
                 │
                 ▼
   ┌──────────────────────────┐
   │     TRANSMIT SIGNAL       │──── S106
   └──────────────────────────┘
                 │
                 ▼
        ┌──────────────────┐
        │       END        │
        └──────────────────┘
```

# FIG. 6

```
                    ┌──────────────┐
                    │    START     │
                    └──────┬───────┘
                           │
                           ▼
              ┌─────────────────────────┐
              │    RECEIVE SIGNAL        │──── S201
              └────────────┬────────────┘
                           │
                           ▼
              ┌─────────────────────────┐
              │    CALCULATE LOG         │──── S202
              │    LIKELIHOOD RATIOS     │
              └────────────┬────────────┘
                           │
                           ▼
              ┌─────────────────────────┐
              │   DETERMINE NUMBER OF    │──── S203
              │      ITERATIONS          │
              └────────────┬────────────┘
                           │
                           ▼
              ┌─────────────────────────┐
              │ ERROR CORRECTION DECODING│──── S204
              └────────────┬────────────┘
                           │
                           ▼
              ┌─────────────────────────┐
              │ ERROR CORRECTION DECODING│──── S205
              └────────────┬────────────┘
                           │
                           ▼
              ┌─────────────────────────┐
              │   COUNT NUMBER OF        │──── S206
              │     ITERATIONS           │
              └────────────┬────────────┘
                           │          S207
                           ▼
                   ╱───────────────╲        NO
                  ╱  IS IT DETERMINED╲──────────┐
                  ╲  NUMBER OF TIMES? ╱          │
                   ╲─────────┬───────╱           │
                         YES │                   │
                             ▼                   │
              ┌─────────────────────────┐        │
              │   COMPLETE DECODING      │──── S208│
              └────────────┬────────────┘        │
                           │                     │
                           ▼                     │
                    ┌──────────────┐             │
                    │     END      │             │
                    └──────────────┘             │
```

## INTERNATIONAL SEARCH REPORT

International application No.

PCT/JP2009/052400

A. CLASSIFICATION OF SUBJECT MATTER
*H03M13/29(2006.01)i*

According to International Patent Classification (IPC) or to both national classification and IPC

B. FIELDS SEARCHED

Minimum documentation searched (classification system followed by classification symbols)
H03M13/29

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-6382 A (Matsushita Electric Industrial Co., Ltd.), 11 January, 2007 (11.01.07), Full text; all drawings & WO 2007/000917 A1 | 1-9 |
| A | JP 2004-229169 A (Hitachi Kokusai Electric Inc.), 12 August, 2004 (12.08.04), Full text; all drawings (Family: none) | 1-9 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 06 April, 2009 (06.04.09) | Date of mailing of the international search report 14 April, 2009 (14.04.09) |
|---|---|
| Name and mailing address of the ISA/ Japanese Patent Office | Authorized officer |
| Facsimile No. | Telephone No. |

Form PCT/ISA/210 (second sheet) (April 2007)

19

**INTERNATIONAL SEARCH REPORT**

| International application No. |
| --- |
| PCT/JP2009/052400 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2000-513555 A (Samsung Electronics Co., Ltd.), 10 October, 2000 (10.10.00), Full text; all drawings & US 7372921 B2 & US 6885710 B1 & EP 990307 A1 & EP 1722477 A2 & WO 1999/055008 A1 & KR 429506 B1 & AU 3345999 A & BR 9906360 A & CA 2292568 A & AU 733641 B & RU 2212100 C & CN 1263649 A | 1-9 |
| A | Ibrahim A. Al-Mohandes et al., A New Efficient Dynamic-Iterative Technique for Turbo Decoders, Proceedings of the 2002 45$^{th}$ Midwest Symposium on Circuits and Systems, 2000. (MWSCAS-2002), Vol.3, 4-7 August 2002, pp.III-180 – III-183 | 1-9 |
| A | Byoug-Sup Shim et al., A New Stopping Criterion for Turbo codes, Proceedings of the 8$^{th}$ International Conference, Advanced Communication Technology, 2006. (ICACT 2006), Vol.2, 20-22 February 2006, pp.1107-1111 | 1-9 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008033252 A
- JP 2000183758 A